# FASCICULE DE BREVET EUROPEEN

(11) **EP 4 440 840 B1**
(45) Date de publication et mention de la délivrance du brevet: **27.08.2025**
(21) Numéro de dépôt: 22817158.3
(22) Date de dépôt: 09.11.2022
(51) Int. Cl.: B32B 43/00, B23D 57/00, B23D 59/00, B26D 1/46, B28D 1/00, B28D 5/00, H10F 19/80

(54) **INSTALLATION ET PROCÉDÉ DE DÉSASSEMBLAGE D'UN MODULE PHOTOVOLTAÏQUE**
VORRICHTUNG UND VERFAHREN ZUM DEMONTIEREN EINES FOTOVOLTAISCHEN MODULS
APPARATUS AND METHOD FOR DISMANTLING A PHOTOVOLTAIC MODULE

(30) Priorité: 29.11.2021 FR 2112657
(43) Date de publication de la demande: 09.10.2024
(73) Titulaire: Commissariat à l'Energie Atomique et aux Energies Alternatives, 75015 Paris (FR)
(72) Inventeur: COUSTIER, Fabrice, 38054 Grenoble cedex 09 (FR); DE BETTIGNIES, Rémi, 38054 Grenoble cedex 09 (FR); RIVA, Roland, 38054 Grenoble cedex 09 (FR)
(74) Mandataire: INNOV-GROUP
(86) Numéro de dépôt international: PCT/EP2022/081254
(87) Numéro de publication internationale: WO 2023/094155

(56) Documents cités:
- WO-A1-2019/043329
- CN-B- 103 085 116

## Description

### Domaine technique de l'invention

La présente invention se rapporte à une installation et à un procédé de désassemblage d'un module photovoltaïque.

### Etat de la technique

De manière connue, un module photovoltaïque comporte des cellules photovoltaïques destinées à convertir une énergie solaire en une énergie électrique.

Un tel module photovoltaïque comporte de nombreux matériaux intéressants à récupérer et à valoriser, lorsque le module est en fin de vie ou défaillant.

Classiquement, un module photovoltaïque se présente sous la forme d'un panneau composé par l'assemblage de trois couches superposées et fixées entre elles :
- Une première couche (appelée "backsheet") formant un premier élément de protection en face arrière ;
- Une deuxième couche, dite couche intermédiaire ; cette couche intermédiaire comporte les cellules photovoltaïques, la connectique électrique entre les cellules et une enveloppe d'encapsulation arrangée autour des cellules photovoltaïques ;
- Une troisième couche formant un deuxième élément de protection en face avant ; cette troisième couche peut être en verre pour être traversée par les rayons lumineux captés ;

La demande de brevet WO2019/043329A1 décrit une installation et un procédé de désassemblage d'un module photovoltaïque, utilisant un fil abrasif, par exemple un fil diamanté, se déplaçant en translation entre deux couches du module pour les séparer. En utilisant cette solution antérieure, on a constaté qu'il est plus facile de découper dans les zones où le fil vient en contact avec les cellules photovoltaïques en silicium que dans les zones inter-cellules où il n'y a que le matériau d'encapsulation (en général de l'EVA). Si le fil abrasif est contrôlé à la même vitesse dans les deux types de zones, il peut avoir tendance à faire fondre l'EVA et ainsi à se dégrader au cours du temps en perdant ses qualités de coupe. Pour éviter cela, la meilleure solution est d'adapter la vitesse d'avance du fil dans le plan de découpe et éventuellement sa vitesse de coupe (définie suivant un axe perpendiculaire à celui de sa progression dans le module), lorsque le fil est situé dans une zone qui ne comporte que de l'EVA. Mais cela suppose bien entendu de connaître la position du fil lors de la découpe.

Différentes solutions ont déjà été proposées dans l'état de la technique pour mesurer la flèche d'un fil lors d'une découpe. On peut notamment citer les demandes de brevets EP2583778A1**,** EP2708342A1**.** Ces solutions utilisent par exemple des capteurs de type ultrasonore, inductif, capacitif.

Le document CN103085116 décrit pour sa part une solution de découpe utilisant des capteurs pour gérer le mouvement du fil de découpe.

Le but de l'invention est de proposer une installation de désassemblage d'un module photovoltaïque qui utilise un fil abrasif et qui permette de tenir compte de la position du fil lors de la découpe afin de pouvoir mieux régler la vitesse d'avance et/ou la vitesse de coupe du fil.

### Exposé de l'invention

Ce but est atteint par une installation de désassemblage d'un module photovoltaïque, ledit module photovoltaïque comprenant au moins un premier élément de protection formant une face avant transparente du module, un deuxième élément de protection formant une face arrière du module photovoltaïque, des cellules photovoltaïques agencées entre le premier élément de protection et le deuxième élément de protection, une enveloppe d'encapsulation des cellules photovoltaïques reliant le premier élément de protection au deuxième élément de protection, ladite installation comprenant :
- Un plateau support présentant une face d'appui contre laquelle vient prendre appui ledit module photovoltaïque à désassembler, par sa face avant transparente,
- Un fil abrasif contrôlé pour se déplacer suivant une direction de translation et dans un plan, dit de découpe, situé entre la face avant et la face arrière du module photovoltaïque pour découper le module photovoltaïque suivant ce plan de découpe,
- Des moyens d'entraînement du fil abrasif pour le déplacer dans ledit plan de découpe à une vitesse d'avance suivant une première direction et/ou à une vitesse de coupe suivant une deuxième direction,
- Un dispositif de rétroéclairage, agencé pour émettre des signaux lumineux à travers le module photovoltaïque, en vue de déterminer la position du fil abrasif lors de la découpe,
- Des moyens de réglage de la vitesse d'avance et/ou de coupe du fil abrasif, la ou lesdites vitesses étant réglées pour tenir compte de la position du fil abrasif préalablement déterminée.

Selon une particularité, le dispositif de rétroéclairage comporte plusieurs éléments lumineux agencés dans un plan parallèle au plan de découpe et de manière échelonnée suivant une direction parallèle à la direction de translation dudit fil abrasif.

Selon une autre particularité, les éléments lumineux sont insérés entre le plateau support et la face avant du module photovoltaïque.

Selon une autre particularité, chaque élément lumineux comporte un ruban d'une ou plusieurs diodes électroluminescentes.

Selon une autre particularité, les rubans de diodes électroluminescentes sont connectés entre eux pour former une guirlande.

Selon une autre particularité, le plateau support est réalisé dans un matériau transparent et en ce que la source émettrice de lumière est agencée du côté de la face du plateau qui est opposée à sa face d'appui sur le module.

Selon une autre particularité, les moyens de réglage de la position du fil abrasif comportent :
- Des moyens de capture optique des signaux lumineux émis à travers ledit module photovoltaïque,
- Une unité de contrôle configurée pour déterminer la position du fil abrasif dans ledit plan de découpe, par analyse de données reçues en provenance des moyens de capture optique et représentatives desdits signaux lumineux captés, et pour régler la vitesse d'avance et/ou de coupe du fil abrasif en tenant compte de la position déterminée du fil abrasif.

Selon une autre particularité, les moyens de capture optique comportent au moins une caméra et/ou un ou plusieurs capteurs.

Selon une autre particularité, l'unité de contrôle est configurée pour :
- Commander une capture des premiers signaux optiques émis à travers le module photovoltaïque par le dispositif de rétroéclairage, en l'absence du fil abrasif, pour obtenir des premières données représentatives de ces premiers signaux optiques,
- Lors de la découpe, commander à chaque instant une capture de deuxièmes signaux optiques émis à travers le module photovoltaïque par le dispositif de rétroéclairage, pour obtenir des deuxièmes données représentatives de ces deuxièmes signaux optiques,
- Comparer les premières données aux deuxièmes données en vue de déterminer la position du fil abrasif à travers le module photovoltaïque.

L'invention concerné également un procédé de désassemblage d'un module photovoltaïque, ledit module photovoltaïque comprenant au moins un premier élément de protection formant une face avant transparente du module, un deuxième élément de protection formant une face arrière du module photovoltaïque, des cellules photovoltaïques agencées entre le premier élément de protection et le deuxième élément de protection, une enveloppe d'encapsulation des cellules photovoltaïques reliant le premier élément de protection au deuxième élément de protection, ledit procédé étant mis en œuvre sur une installation de désassemblage telle que définie ci-dessus,

Ledit procédé comportant :
- Une étape d'émission de signaux lumineux à travers le module photovoltaïque en utilisant un dispositif de rétroéclairage,
- Une étape de détermination de la position du fil abrasif dans ledit plan de découpe,
- Une étape de réglage de la vitesse d'avance et/ou de coupe du fil abrasif en tenant compte de la position déterminée du fil abrasif.

Selon une particularité, le procédé comporte également :
- Une étape de capture des signaux lumineux émis à travers ledit module photovoltaïque par ledit dispositif de rétroéclairage,
- Une étape de détermination de la vitesse du fil abrasif par analyse de données représentatives desdits rayonnement lumineux captés.

Selon une autre particularité, l'étape de détermination de la position du fil abrasif comporte des étapes de :
- Acquisition de premières données représentatives de premiers signaux optiques émis à travers le module photovoltaïque par le dispositif de rétroéclairage,
- Lors de la découpe, acquisition de deuxièmes données représentatives de deuxièmes signaux optiques émis à travers le module photovoltaïque par le dispositif de rétroéclairage, en présence du fil abrasif,
- Comparaison les premières données aux deuxièmes données en vue de déterminer la position du fil abrasif à travers le module photovoltaïque.

### Brève description des figures

D'autres caractéristiques et avantages vont apparaître dans la description détaillée qui suit faite en regard des dessins annexés dans lesquels :
- La figure 1 représente, vue en perspective, l'architecture multicouches d'un module photovoltaïque ;
- La figure 2 représente, vue en coupe transversale, l'architecture multicouches d'un module photovoltaïque ;
- La figure 3 montre la couche intermédiaire du module photovoltaïque, en vue de dessus, avec les cellules photovoltaïques en transparence ;
- La figure 4 montre de manière schématique une installation classique de découpe d'un module photovoltaïque ;
- La figure 5 illustre de manière schématique l'installation de l'invention et son principe de fonctionnement ;
- La figure 6 illustre de manière schématique l'installation de l'invention et son principe de fonctionnement, selon un exemple particulier de réalisation ;
- La figure 7A et la figure 7B représentent, par une vue de dessus, l'exemple de réalisation de l'installation de l'invention de la figure 6, en cours de découpe à deux instants différents ;

### Description détaillée d'au moins un mode de réalisation

Dans la suite de la description, la face avant du module photovoltaïque M correspond à une face du module recevant les rayons lumineux et la face arrière correspond à la face opposée à la face avant.

Dans la suite de la description, chaque couche du module photovoltaïque présente deux faces opposées, une première face orientée vers l'arrière et une deuxième face orientée vers l'avant.

Ci-après, par "élément de protection", on entend un élément pouvant présenter une fonction de rigidification et/ou une fonction de protection de surface.

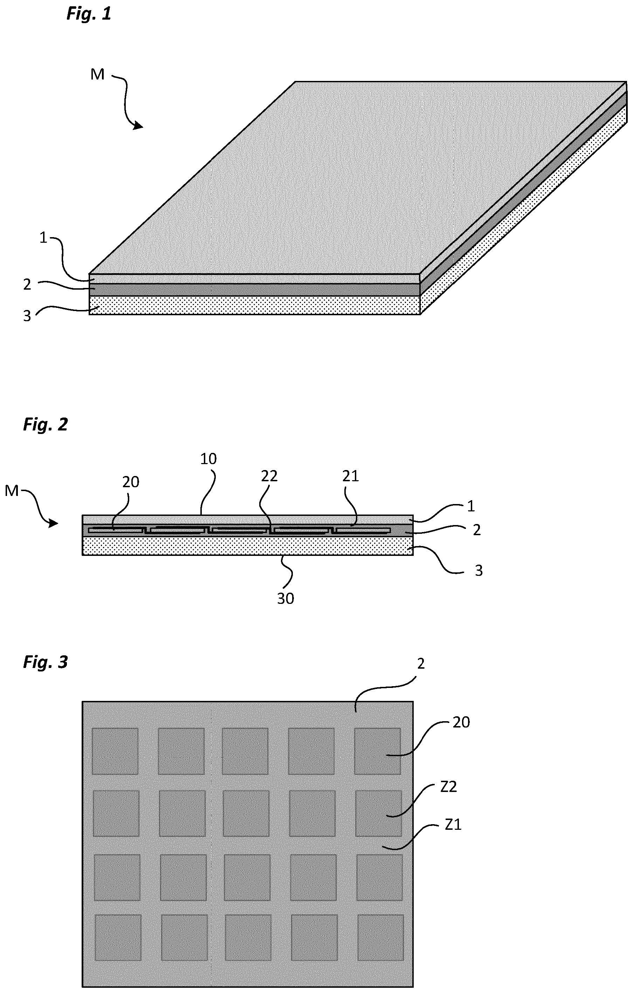

En référence à la figure 1 et à la figure 2, de manière connue, un module photovoltaïque comporte plusieurs couches superposées et assemblées entre elles :
- Une première couche 1 (appelée couramment "backsheet") formant un premier élément de protection en face arrière ; cette première couche est habituellement réalisée dans un matériau de type polymère ;
- Une deuxième couche 2, dite couche intermédiaire, intercalée entre la première couche et la troisième couche (décrite ci-dessous), permettant l'assemblage d'un côté de la première couche et de l'autre côté de la troisième couche ; cette couche intermédiaire comporte les cellules photovoltaïques 20, la connectique électrique 22 et une enveloppe d'encapsulation 21 arrangée autour des cellules photovoltaïques ;
- Une troisième couche 3 formant un deuxième élément de protection en face avant ; cette troisième couche 3 est habituellement en verre mais elle peut éventuellement être formée d'un polymère transparent ;

Il faut noter que sur les figures annexées, le module photovoltaïque M est représenté retourné, de sorte que sa face arrière est située au-dessus et la face avant est située au-dessous.

Pour des soucis de lisibilité sur les figures annexées, les différentes couches du module ne sont pas représentées à l'échelle. A titre d'exemple, la première couche 1 peut présenter une épaisseur de quelques centaines de µm (par exemple environ 350 µm), la deuxième couche 2 peut présenter une épaisseur pouvant aller jusqu'à 1 mm et la troisième couche 3 peut présenter une épaisseur d'environ 3 à 4 mm.

La première couche 1 peut notamment assurer une fonction d'imperméabilité aux gaz et à l'eau, une fonction de protection/isolation électrique et une fonction de protection mécanique. Cette première couche 1 peut être réalisée à base d'un polymère fluoré. Il peut s'agir du polyfluorure de vinyle (PVF), par exemple commercialisé sous le nom TEDLAR (marque déposée) par la société DuPont (marque déposée).

De manière non limitative, la première couche 1 peut elle-même être composée d'un empilement de plusieurs strates : une strate de PVF, une strate en PET (poly(téréphtalate) d'éthylène), une strate de PVF.

Dans la couche intermédiaire 2, l'enveloppe d'encapsulation 21 est classiquement réalisée dans un polymère tel que de l'EVA (Ethylène-Acétate de Vinyl) formant un matériau sur lequel peuvent adhérer la première couche 1 d'un côté et la troisième couche 3 de l'autre côté et permettre l'assemblage des trois couches entre elles. Les trois couches peuvent être assemblées entre elles par laminage à chaud, de sorte que la première couche et la troisième couche viennent adhérer au matériau de l'enveloppe d'encapsulation, formant ainsi un empilement monobloc.

Dans la couche intermédiaire 2, les cellules photovoltaïques 20 sont connectées entre elles, en série/parallèle, formant plusieurs chaînes ("string" en anglais) de cellules. Des éléments de connexion électrique 22, par exemple en cuivre, permettent d'assurer les liaisons électriques entre les cellules 20 dans chaque chaîne.

Le module photovoltaïque M peut comporter un cadre (non représenté), par exemple en aluminium, agencé en périphérie de l'empilement pour rigidifier le module M. Pour la mise en œuvre de l'invention décrite ci-dessous, ce cadre, ainsi que la boîte de jonction électrique (non représentée) généralement fixée sur la face arrière du module M, sont préalablement retirés. Le procédé de l'invention est en effet dédié plus particulièrement au traitement de l'empilement de couches du module photovoltaïque M.

L'invention vise une installation de désassemblage d'un module photovoltaïque M, utilisant un fil abrasif F.

Le fil abrasif F est piloté pour se déplacer en translation dans un plan, dit plan de découpe, pour séparer les différentes couches du module photovoltaïque. Le fil abrasif est alors piloté pour se déplacer suivant une direction de translation Y à une vitesse, dite vitesse d'avance.

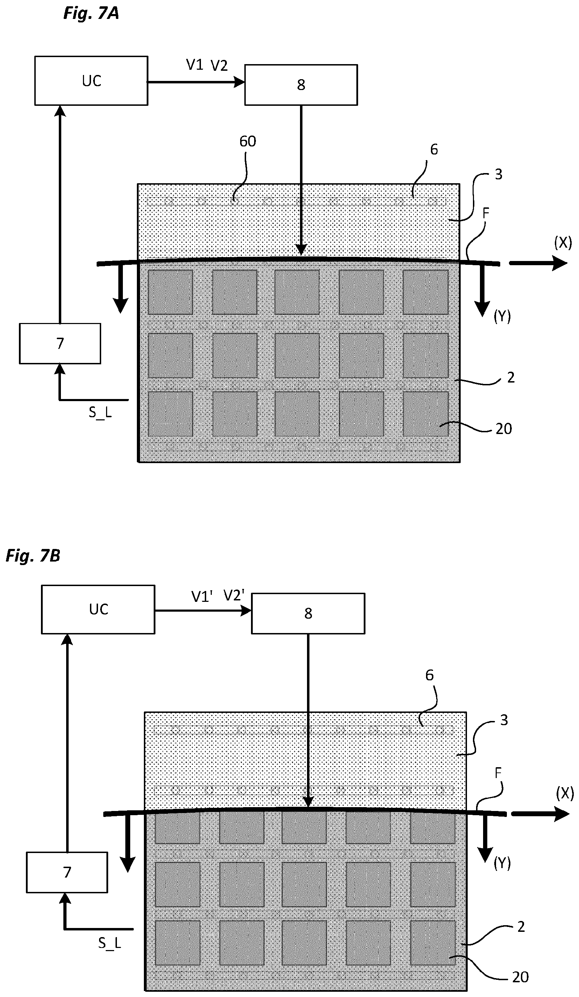

Le fil abrasif F peut également être piloté pour se déplacer suivant une direction X perpendiculaire à sa direction Y de progression et situé dans le plan de découpe. Le fil est alors par exemple tendu entre des poulies et entraîné entre les poulies à une vitesse dite vitesse de coupe. Les deux directions de déplacement X, Y du fil sont représentées sur la figure 7A.

Le plan de découpe est parallèle au plan du module M et par exemple situé au niveau de la couche intermédiaire. Comme illustré par la figure 3 montrant la couche intermédiaire 2, lors de la découpe, le fil abrasif F sera amené à rencontrer des zones Z2 comportant le matériau d'encapsulation (par exemple de l'EVA) et des cellules photovoltaïques et des zones inter-cellules Z1 qui ne comportent que le matériau d'encapsulation. Comme indiqué ci-dessus, l'invention présente notamment un intérêt lorsque le fil abrasif F est amené à découper le module suivant ce plan de découpe, en vue de pouvoir ajuster la vitesse d'avance et/ou de coupe du fil abrasif F lors de la découpe. Mais le principe de l'invention reste adaptable pour la découpe de toutes les couches du module photovoltaïque M.

Le fil abrasif F est entraîné par des moyens d'entraînement 8 de l'installation, recevant en entrée une consigne de vitesse d'avance V1 du fil abrasif F et/ou une consigne de vitesse de coupe V2 du fil abrasif F.

De manière non limitative, les moyens d'entraînement 8 peuvent par exemple comporter plusieurs moteurs électriques commandés par des variateurs de vitesse.

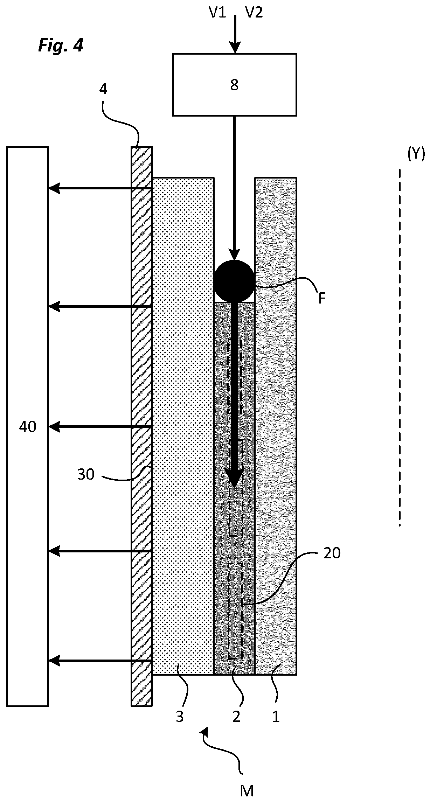

En référence à la figure 4, une installation de désassemblage comporte avantageusement un plateau support 4. Lors de la découpe, le module photovoltaïque M est mis en appui par sa face avant 30 contre une face externe de ce plateau support 4.

Le plateau support 4 peut notamment être réalisé dans un matériau de type aluminium ou équivalent. On verra également qu'il peut être réalisé dans un matériau transparent, suffisamment résistant mécaniquement comme le PMMA (Poly(méthacrylate de méthyle), le COC ("Cyclic Olefin Copolymer") ou matériau équivalent.

L'installation peut comporter des moyens permettant de maintenir le module photovoltaïque en position fixe contre le plateau support 4. Ces moyens peuvent notamment comporter un système de pompage 40 chargé de plaquer le module photovoltaïque M contre le plateau support par aspiration. Le plateau support 4 peut ainsi comporter plusieurs ouvertures (non représentées) à travers lesquelles l'aspiration est réalisée par le système de pompage.

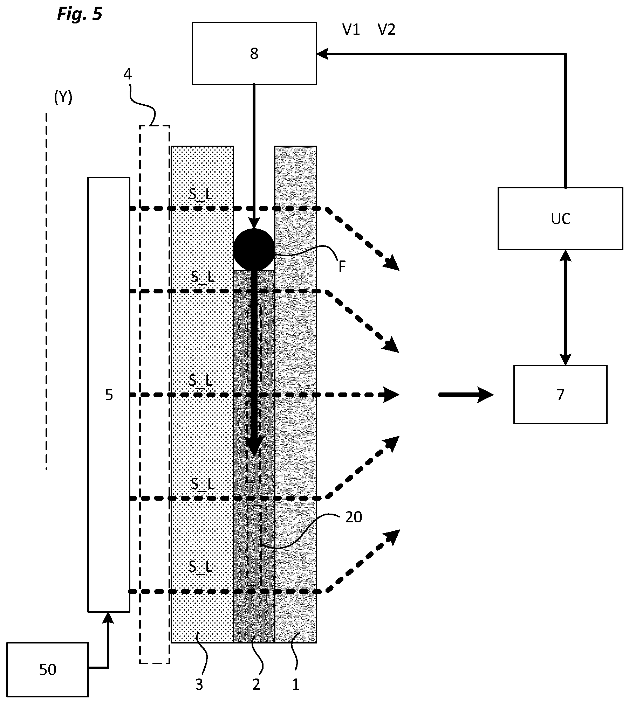

En référence à la figure 5, selon l'invention, l'installation comporte un dispositif de rétroéclairage 5 utilisé pour déterminer la position du fil abrasif F par transparence à travers le module photovoltaïque M lorsque le fil abrasif D est en cours de découpe, lors de son avancée en translation à travers le module.

Le dispositif de rétroéclairage 5 permet d'émettre des signaux lumineux S_L à travers le module photovoltaïque M, en vue de pouvoir in fine détecter la position du fil abrasif F en cours de déplacement et de pouvoir éventuellement mieux contrôler la vitesse d'avance et/ou de coupe du fil abrasif F lors de la découpe en fonction de sa position, les moyens d'entraînement 8 du fil abrasif F recevant en entrée la consigne de vitesse d'avance V1 et/ou la consigne de vitesse de coupe V2 tenant compte de cette position déterminée.

Le dispositif de rétroéclairage 5 est agencé et configuré pour éclairer à travers toute la surface du module photovoltaïque M.

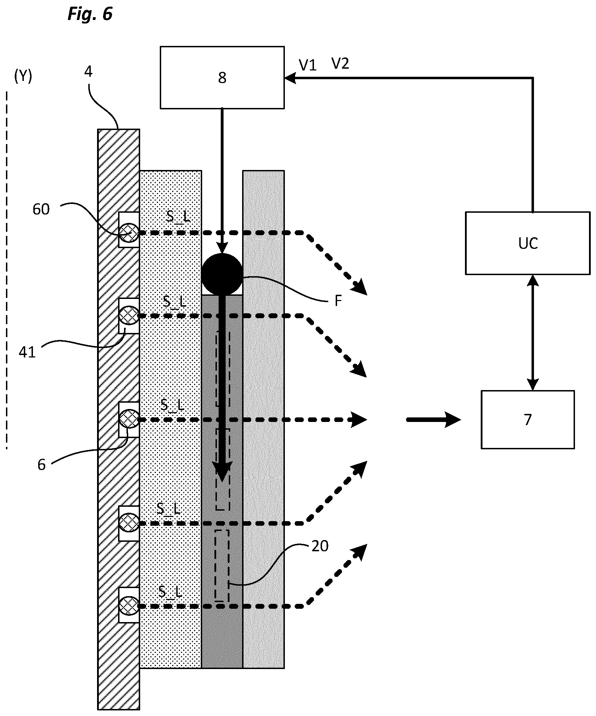

Le dispositif de rétroéclairage 5 peut être agencé par rapport au plateau support 4, du côté de la face opposée à la face d'appui du module photovoltaïque M, si le plateau support 4 est réalisé dans un matériau transparent (comme sur la figure 5) ou entre le plateau support et le module photovoltaïque, si par exemple le plateau support 4 est réalisé dans un matériau opaque ou peu transparent (comme dans l'exemple de réalisation de la figure 6).

Par le terme "transparent", on entend que le matériau employé est au moins partiellement transparent à la lumière visible, de manière à laisser passer au moins 80% de cette lumière. Il faut ainsi comprendre qu'il sera suffisamment transparent pour pouvoir déterminer la position du fil abrasif lors de la découpe par rétroéclairage.

En référence à la figure 6, le dispositif de rétroéclairage 5 peut comporter une source émettrice de lumière par exemple composée d'un ou plusieurs éléments lumineux 6 agencés de manière adaptée pour fournir des signaux lumineux S_L à travers toute la surface du module photovoltaïque M.

Chaque élément lumineux 6 peut comporter une ou plusieurs diodes électroluminescentes 60.

Les éléments lumineux 6 peuvent être connectés entre eux, en série et/ou parallèle, de manière à former une guirlande.

Les éléments lumineux 6 peuvent être agencés de manière échelonnée le long de la direction de translation (A) du fil abrasif F, dans un plan parallèle au plan de découpe. Le dispositif de rétroéclairage 5 comporte une source d'alimentation électrique 50, sur laquelle est connecté chacun de ses éléments lumineux 6.

Selon une particularité, chaque élément lumineux peut se présenter sous la forme d'une bande de plusieurs diodes électroluminescentes 60. Chaque bande est par exemple insérée dans une rainure 41 réalisée sur la face d'appui du plateau support 4. Les rainures sont par exemple toutes parallèles et réalisées sur la face d'appui du plateau support 4, et par exemple agencées perpendiculairement à la direction de translation du fil abrasif F. Bien entendu, d'autres configurations de position des bandes de diodes électroluminescentes pourraient être envisagées, dès l'instant qu'un rétroéclairage suffisant est fourni.

La position du fil abrasif F lors de la découpe peut être déterminée par simple visualisation par un opérateur, qui peut ensuite régler manuellement chaque consigne appliquée aux moyens d'entraînement 8 chargés d'entraîner le fil abrasif F.

De manière avantageuse, l'installation peut aussi comporter des moyens de capture optique 7 des signaux lumineux S_L émis à travers ledit module photovoltaïque M. Ces moyens de capture optique 7 peuvent comporter une caméra et/ou un ou plusieurs capteurs optiques capables de capter lesdits signaux lumineux S_L émis à travers le module photovoltaïque par le dispositif de rétroéclairage 5.

Les moyens de capture optique 7 sont positionnés du côté opposé au dispositif de rétroéclairage 5, par rapport au plan formé par le module photovoltaïque M, de manière à capter les signaux lumineux S_L émis par le dispositif de rétroéclairage 5 à travers le module photovoltaïque M.

L'installation comporte alors une unité de contrôle UC recevant des données représentatives des signaux lumineux S_L captés par les moyens de capture optique 7. Les données reçues par l'unité de contrôle UC peuvent être de type analogique et/ou numérique. L'unité de contrôle UC peut être un automate programmable.

L'unité de contrôle UC est configurée pour déterminer la position du fil abrasif F lors de la découpe, par analyse des données reçues.

En fonction de la position du fil abrasif F, l'unité de contrôle UC est configurée pour régler la vitesse d'avance du fil abrasif F et/ou la vitesse de coupe du fil abrasif F dans le plan de découpe. Les consignes de vitesse V1, V2 déterminées sont envoyées aux moyens d'entraînement 8.

Selon un aspect particulier de l'invention, la détermination de la position du fil abrasif F peut être réalisée à partir du contraste lumineux existant entre les zones non occupées par le fil abrasif F et les zones occupées par le fil abrasif F.

Selon que l'éclairage est réalisé dans le visible ou dans l'infrarouge, le principe de détection de la position du fil abrasif F pourra différer. Comme déjà indiqué ci-dessus, les zones occupées par les rubans de connexion et par les cellules photovoltaïques, sont dites zones pleines Z2, par opposition aux zones inter-cellules Z1 (voir figure 3).

### Eclairage dans le visible :

En l'absence du fil abrasif, avant l'opération de découpe, la lumière émise par le dispositif de rétroéclairage 5 traverse les zones inter-cellules Z1 où il n'y a aucun ruban de connexion ni cellule photovoltaïque, et ne traverse pas ou moins les zones pleines Z2.

Lors de la découpe, le passage du fil abrasif F à l'intérieur du module photovoltaïque M dans le plan de découpe modifie la transmission de la lumière à travers le module, les zones inter-cellules Z1 traversées par le fil abrasif F devenant alors plus sombres (car moins denses) et ainsi détectables.

### Eclairage dans l'infrarouge :

En l'absence du fil abrasif, avant l'opération de découpe, la lumière émise par le dispositif de rétroéclairage 5 traverse les zones pleines Z2, les cellules étant transparentes aux infrarouges, et ne traversent pas ou moins les zones inter-cellules Z1.

Lors de la découpe, le passage du fil abrasif F à l'intérieur du module photovoltaïque M dans le plan de découpe modifie la transmission de la lumière à travers le module, les zones inter-cellules Z1 traversées par le fil abrasif F devenant alors visibles et ainsi détectables.

L'unité de contrôle UC est bien entendu configurée pour traiter les différences de contraste.

A titre d'exemple, pour déterminer la position du fil abrasif F, l'unité de contrôle UC peut procéder de la manière suivante :
- L'unité de contrôle UC commande les moyens de capture optique 7 pour générer une première capture du module photovoltaïque M rétroéclairé, avant ouverture (passage du fil abrasif) ; il s'agit ainsi d'une phase de cartographie du module photovoltaïque M.
- L'unité de contrôle mémorise la première capture du module photovoltaïque M rétroéclairé.
- A partir de la première capture, l'unité de contrôle UC détermine les zones pleines Z2 et les zones inter-cellules Z1.
- Lors de la découpe, l'unité de contrôle UC peut être amenée à comparer la première capture avec une nouvelle capture prise à chaque instant afin de détecter les zones de contraste et déterminer si le fil abrasif se situe dans une zone pleine Z2 ou dans une zone inter-cellules Z1.
- En fonction de la position du fil abrasif F, par rapport aux zones pleines Z2 et aux zones inter-cellules Z1, l'unité de contrôle UC détermine la consigne de vitesse d'avance V1 et/ou de coupe V2 à appliquer au fil abrasif F.
- Les consignes de vitesse V1, V2 déterminées sont par exemple chacune envoyées en entrée d'une boucle de régulation en vitesse distincte mise en œuvre par les moyens d'entraînement 8 du fil abrasif.

Sur la figure 7A, on peut voir le fil abrasif F en cours de découpe à travers une zone inter-cellules Z1, le fil abrasif F est alors commandé à la vitesse d'avance V1 et à une vitesse de coupe V2.

Sur la figure 7B, on peut voir le fil abrasif F en cours de découpe à travers une zone pleine Z2, le fil abrasif F est alors entraîné avec une vitesse d'avance V1' et à une vitesse de coupe V2', par exemple différente des consignes de vitesse V1, V2 pour tenir compte des différences de matériau entre les deux zones.

Si l'installation utilise des moyens de capture optique 7 de type caméra, la caméra est par exemple apte à capturer une image du module photovoltaïque soumis au rétroéclairage, avant la découpe, en l'absence du fil abrasif F et des images successives au fur et à mesure de l'avancée en translation du fil abrasif F. L'unité de contrôle UC peut comparer l'image capturée initialement aux images capturées à plusieurs instants successifs lors de la découpe pour déterminer les zones d'ombre distinctes et en déduire la position du fil abrasif F.

L'installation peut utiliser des moyens de capture optique 7 de type capteurs optiques répartis pour capter les signaux lumineux S_L émis à travers toute la surface du module photovoltaïque M. L'unité de contrôle UC peut détecter les variations d'intensité des signaux lumineux S_L reçus par chaque capteur et en déduire la position du fil abrasif F.

L'invention présente de nombreux avantages, parmi lesquels :
- Elle permet de déterminer la position du fil abrasif lors de la découpe de manière simple ;
- De manière avantageuse, elle permet de pouvoir adapter automatiquement la vitesse d'avancée du fil abrasif lors de la découpe, en tenant compte des types de matériau rencontrés ;
- Elle est adaptable aux solutions de découpe existantes, par exemple en venant insérer les rubans de diodes électroluminescentes dans les rainures prévues sur le plateau support 4

## Revendications

1. Installation de désassemblage d'un module photovoltaïque (M), ledit module photovoltaïque (M) comprenant au moins un premier élément de protection (3) formant une face avant transparente du module, un deuxième élément de protection (1) formant une face arrière du module photovoltaïque, des cellules photovoltaïques (20) agencées entre le premier élément de protection (3) et le deuxième élément de protection (1), une enveloppe d'encapsulation (2) des cellules photovoltaïques reliant le premier élément de protection au deuxième élément de protection, ladite installation comprenant :
- Un plateau support (4) présentant une face d'appui contre laquelle vient prendre appui ledit module photovoltaïque (M) à désassembler, par sa face avant transparente,
- Un fil abrasif (F) contrôlé pour se déplacer suivant une direction de translation et dans un plan, dit de découpe, situé entre la face avant et la face arrière du module photovoltaïque (M) pour découper le module photovoltaïque suivant ce plan de découpe,
- Des moyens d'entraînement (8) du fil abrasif (F) pour le déplacer dans ledit plan de découpe à une vitesse d'avance (V1) suivant une première direction et/ou à une vitesse de coupe (V2) suivant une deuxième direction,
- **Caractérisée en ce que** l'installation comporte :
- Un dispositif de rétroéclairage (5), agencé pour émettre des signaux lumineux (S_L) à travers le module photovoltaïque (M), en vue de déterminer la position du fil abrasif (F) lors de la découpe,
- Des moyens de réglage de la vitesse d'avance (V1) et/ou de coupe (V2) du fil abrasif (F), la ou lesdites vitesses étant réglées pour tenir compte de la position du fil abrasif (F) préalablement déterminée.

2. Installation selon la revendication 1, **caractérisée en ce que** le dispositif de rétroéclairage (5) comporte plusieurs éléments lumineux (6) agencés dans un plan parallèle au plan de découpe et de manière échelonnée suivant une direction parallèle à la direction de translation dudit fil abrasif (F).

3. Installation selon la revendication 2, **caractérisée en ce que** les éléments lumineux (6) sont insérés entre le plateau support (4) et la face avant du module photovoltaïque.

4. Installation selon la revendication 2 ou 3, **caractérisée en ce que** chaque élément lumineux comporte un ruban d'une ou plusieurs diodes électroluminescentes.

5. Installation selon la revendication 4, **caractérisée en ce que** les rubans de diodes électroluminescentes sont connectés entre eux pour former une guirlande.

6. Installation selon la revendication 1 ou 2, **caractérisée en ce que** le plateau support est réalisé dans un matériau transparent et **en ce que** la source émettrice de lumière est agencée du côté de la face du plateau qui est opposée à sa face d'appui sur le module.

7. Installation selon l'une des revendications 1 à 6, **caractérisée en ce que** les moyens de réglage de la position du fil abrasif (F) comportent :
- Des moyens de capture optique (7) des signaux lumineux (S_L) émis à travers ledit module photovoltaïque (M),
- Une unité de contrôle (UC) configurée pour déterminer la position du fil abrasif (F) dans ledit plan de découpe, par analyse de données reçues en provenance des moyens de capture optique (7) et représentatives desdits signaux lumineux (S_L) captés, et pour régler la vitesse d'avance (V1) et/ou de coupe (V2) du fil abrasif (F) en tenant compte de la position déterminée du fil abrasif (F).

8. Installation selon la revendication 7, **caractérisée en ce que** les moyens de capture optique (7) comportent au moins une caméra et/ou un ou plusieurs capteurs.

9. Installation selon la revendication 7 ou 8, **caractérisée en ce que** l'unité de contrôle (UC) est configurée pour :
- Commander une capture des premiers signaux optiques émis à travers le module photovoltaïque (M) par le dispositif de rétroéclairage (5), en l'absence du fil abrasif (F), pour obtenir des premières données représentatives de ces premiers signaux optiques,
- Lors de la découpe, commander à chaque instant une capture de deuxièmes signaux optiques émis à travers le module photovoltaïque (M) par le dispositif de rétroéclairage (5), pour obtenir des deuxièmes données représentatives de ces deuxièmes signaux optiques,
- Comparer les premières données aux deuxièmes données en vue de déterminer la position du fil abrasif (F) à travers le module photovoltaïque (M).

10. Procédé de désassemblage d'un module photovoltaïque (M), ledit module photovoltaïque comprenant au moins un premier élément de protection (3) formant une face avant transparente du module, un deuxième élément de protection (1) formant une face arrière du module photovoltaïque, des cellules photovoltaïques (20) agencées entre le premier élément de protection et le deuxième élément de protection, une enveloppe d'encapsulation (2) des cellules photovoltaïques reliant le premier élément de protection au deuxième élément de protection, ledit procédé étant mis en œuvre sur une installation de désassemblage telle que définie dans l'une des revendications 1 à 9,
Ledit procédé étant **caractérisé en ce qu'**il comporte :
- Une étape d'émission de signaux lumineux (S_L) à travers le module photovoltaïque (M) en utilisant un dispositif de rétroéclairage (5),
- Une étape de détermination de la position du fil abrasif (F) dans ledit plan de découpe,
- Une étape de réglage de la vitesse d'avance (V1) et/ou de coupe (V2) du fil abrasif (F) en tenant compte de la position déterminée du fil abrasif.

11. Procédé selon la revendication 10, **caractérisé en ce qu'**il comporte :
- Une étape de capture des signaux lumineux (S_L) émis à travers ledit module photovoltaïque (M) par ledit dispositif de rétroéclairage (5),
- Une étape de détermination de la vitesse du fil abrasif (V) par analyse de données représentatives desdits rayonnement lumineux (R_L) captés.

12. Procédé selon la revendication 10 ou 11, **caractérisé en ce que** l'étape de détermination de la position du fil abrasif comporte des étapes de :
- Acquisition de premières données représentatives de premiers signaux optiques émis à travers le module photovoltaïque (M) par le dispositif de rétroéclairage (5),
- Lors de la découpe, acquisition de deuxièmes données représentatives de deuxièmes signaux optiques émis à travers le module photovoltaïque (M) par le dispositif de rétroéclairage (5), en présence du fil abrasif (F),
- Comparaison les premières données aux deuxièmes données en vue de déterminer la position du fil abrasif à travers le module photovoltaïque (M).

## Patentansprüche

1. Anlage zum Demontieren eines Photovoltaikmoduls (M), das Photovoltaikmodul (M) umfassend mindestens ein erstes Schutzelement (3), das eine transparente Vorderseite des Moduls bildet, ein zweites Schutzelement (1), das eine Rückseite des Photovoltaikmoduls bildet, Photovoltaikzellen (20), die zwischen dem ersten Schutzelement (3) und dem zweiten Schutzelement (1) angeordnet sind, wobei ein Kapselungsgehäuse (2) der Photovoltaikzellen das erste Schutzelement mit dem zweiten Schutzelement verbindet, wobei die Anlage umfasst:
- eine Trägerplatte (4), die eine Auflageseite aufweist, an der das zu demontierende Photovoltaikmodul (M) mit seiner transparenten Vorderseite zur Anlage kommt,
- einen Schleifdraht (F), der gesteuert wird, um sich entlang einer Translationsrichtung und in einer Ebene, Schneidebene genannt, die zwischen der Vorderseite und der Rückseite des Photovoltaikmoduls (M) liegt, zu bewegen, um das Photovoltaikmodul entlang dieser Schneidebene zu zerschneiden,
- Antriebsmittel (8) des Schleifdrahts (F), um ihn in der Schneidebene mit einer Vorschubgeschwindigkeit (V1) entlang einer ersten Richtung und/oder mit einer Schnittgeschwindigkeit (V2) entlang einer zweiten Richtung zu verlagern,
- **Dadurch gekennzeichnet, dass** die Anlage beinhaltet:
- Eine Hinterleuchtungsvorrichtung (5), die angeordnet ist, um Lichtsignale (S_L) durch das Photovoltaikmodul (M) hindurch zu emittieren, um die Position des Schleifdrahts (F) beim Schneiden zu bestimmen,
- Mittel zum Einstellen der Vorschub- (V1) und/oder Schnittgeschwindigkeit V2) des Schleifdrahts (F), wobei die Geschwindigkeit oder Geschwindigkeiten eingestellt werden, um die zuvor bestimmte Position des Schleifdrahts (F) zu berücksichtigen.

2. Anlage nach Anspruch 1, **dadurch gekennzeichnet, dass** die Hinterleuchtungsvorrichtung (5) mehrere Leuchtelemente (6) beinhaltet, die in einer parallel zur Schneidebene verlaufenden Ebene und gestaffelt entlang einer parallel zur Translationsrichtung des Schleifdrahts (F) verlaufenden Richtung angeordnet sind.

3. Anlage nach Anspruch 2, **dadurch gekennzeichnet, dass** die Leuchtelemente (6) zwischen der Trägerplatte (4) und der Vorderseite des Photovoltaikmoduls eingefügt sind.

4. Anlage nach Anspruch 2 oder 3, **dadurch gekennzeichnet, dass** jedes Leuchtelement ein Band aus einer oder mehreren Leuchtdioden beinhaltet.

5. Anlage nach Anspruch 4, **dadurch gekennzeichnet, dass** die Bänder aus Leuchtdioden untereinander verbunden sind, um eine Kette zu bilden.

6. Anlage nach Anspruch 1 oder 2, **dadurch gekennzeichnet, dass** die Trägerplatte aus einem transparenten Material ausgeführt ist und dass die Licht emittierende Quelle auf der zu ihrer Anlageseite an dem Modul entgegengesetzten Seite der Platte angeordnet ist.

7. Anlage nach einem der Ansprüche 1 bis 6, **dadurch gekennzeichnet, dass** die Mittel zum Einstellen der Position des Schleifdrahts (F) beinhalten:
- Mittel zur optischen Erfassung (7) der Lichtsignale (S_L), die durch das Photovoltaikmodul (M) hindurch emittiert werden,
- Eine Steuereinheit (UC), die dazu ausgestaltet ist, die Position des Schleifdrahts (F) in der Schneidebene durch Analysieren von Daten zu bestimmen, die von den Mitteln zur optischen Erfassung (7) empfangen werden und für die erfassten Lichtsignale (S_L) repräsentativ sind, und die Vorschub- (V1) und/oder Schnittgeschwindigkeit (V2) des Schleifdrahts (F) unter Berücksichtigung der bestimmten Position des Schleifdrahts (F) einzustellen.

8. Anlage nach Anspruch 7, **dadurch gekennzeichnet, dass** die Mittel zur optischen Erfassung (7) mindestens eine Kamera und/oder einen oder mehrere Sensoren beinhalten.

9. Anlage nach Anspruch 7 oder 8, **dadurch gekennzeichnet, dass** die Steuereinheit (UC) dazu ausgestaltet ist:
- Eine Erfassung der ersten optischen Signale zu steuern, die durch das Photovoltaikmodul (M) hindurch von der Hinterleuchtungsvorrichtung (5) in Abwesenheit des Schleifdrahts (F) emittiert werden, um erste Daten zu erhalten, die für diese ersten optischen Signale repräsentativ sind,
- Beim Schneiden zu jedem Zeitpunkt eine Erfassung von zweiten optischen Signalen zu steuern, die durch das Photovoltaikmodul (M) von der Hinterleuchtungsvorrichtung (5) emittiert werden, um zweite Daten zu erhalten, die für diese zweiten optischen Signale repräsentativ sind,
- Die ersten Daten mit den zweiten Daten zu vergleichen, um die Position des Schleifdrahts (F) durch das Photovoltaikmodul (M) hindurch zu bestimmen.

10. Verfahren zum Demontieren eines Photovoltaikmoduls (M), das Photovoltaikmodul umfassend mindestens ein erstes Schutzelement (3), das eine transparente Vorderseite des Moduls bildet, ein zweites Schutzelement (1), das eine Rückseite des Photovoltaikmoduls bildet, Photovoltaikzellen (20), die zwischen dem ersten Schutzelement und dem zweiten Schutzelement angeordnet sind, wobei ein Kapselungsgehäuse (2) der Photovoltaikzellen das erste Schutzelement mit dem zweiten Schutzelement verbindet, wobei das Verfahren in einer Anlage zum Demontieren nach einem der Ansprüche 1 bis 9 durchgeführt wird,
Wobei das Verfahren **dadurch gekennzeichnet ist, dass** es beinhaltet:
- Einen Schritt des Emittierens von Lichtsignalen (S_L) durch das Photovoltaikmodul (M) hindurch unter Verwendung einer Hinterleuchtungsvorrichtung (5),
- Einen Schritt des Bestimmens der Position des Schleifdrahts (F) in der Schneidebene,
- Einen Schritt des Einstellens der Vorschub- (V1) und/oder Schnittgeschwindigkeit (V2) des Schleifdrahts (F) unter Berücksichtigung der bestimmten Position des Schleifdrahts.

11. Verfahren nach Anspruch 10, **dadurch gekennzeichnet, dass** es beinhaltet:
- Einen Schritt des Erfassens von Lichtsignalen (S_L), die durch das Photovoltaikmodul (M) von der Hinterleuchtungsvorrichtung (5) emittiert werden,
- Einen Schritt des Bestimmens der Geschwindigkeit des Schleifdrahts (V) durch Analysieren von Daten, die für die erfassten Lichtstrahlungen (R_L) repräsentativ sind.

12. Verfahren nach Anspruch 10 oder 11, **dadurch gekennzeichnet, dass** der Schritt des Bestimmens der Position des Schleifdrahts die folgenden Schritte beinhaltet:
- Erfassen von ersten Daten, die für erste optische Signale repräsentativ sind, die durch das Photovoltaikmodul (M) hindurch von der Hinterleuchtungsvorrichtung (5) emittiert werden,
- Beim Scheiden, Erfassen von zweiten Daten, die für zweite optische Signale repräsentativ sind, die durch das Photovoltaikmodul (M) hindurch von der Hinterleuchtungsvorrichtung (5) in Anwesenheit des Schleifdrahts (F) emittiert werden,
- Vergleichen der ersten Daten mit den zweiten Daten zu vergleichen, um die Position des Schleifdrahts durch das Photovoltaikmodul (M) hindurch zu bestimmen.

## Claims

1. Installation for dismantling a photovoltaic module (M), said photovoltaic module (M) comprising at least a first protective element (3) forming a transparent front face of the module, a second protective element (1) forming a back face of the photovoltaic module, photovoltaic cells (20) arranged between the first protective element (3) and the second protective element (1), and an encapsulating housing (2) for the photovoltaic cells connecting the first protective element to the second protective element, said installation comprising:
- a support plate (4) having a bearing face against which the transparent front face of said photovoltaic module (M) to be dismantled bears,
- an abrasive wire (F) controlled for movement in a translational direction and in a plane, referred to as cutting plane, located between the front face and the back face of the photovoltaic module (M) for cutting the photovoltaic module along this cutting plane,
- drive means (8) for the abrasive wire (F) for moving the abrasive wire in said cutting plane at a feed speed (V1) in a first direction and/or at a cutting speed (V2) in a second direction,
- **characterized in that** the installation comprises:
- a back-lighting device (5) designed to emit light signals (S_L) through the photovoltaic module (M), in order to determine the position of the abrasive wire (F) during the cutting,
- means for adjusting the feed speed (V1) and/or the cutting speed (V2) of the abrasive wire (F), said speed(s) being adjusted to take into account the position of the abrasive wire (F) that was determined beforehand.

2. Installation according to Claim 1, **characterized in that** the back-lighting device (5) has multiple luminous elements (6) arranged in a plane parallel to the cutting plane and staggered in a direction parallel to the direction of translational movement of said abrasive wire (F).

3. Installation according to Claim 2, **characterized in that** the luminous elements (6) are inserted between the support plate (4) and the front face of the photovoltaic module.

4. Installation according to Claim 2 or 3, **characterized in that** each luminous element has a strip of one or more light-emitting diodes.

5. Installation according to Claim 4, **characterized in that** the strips of light-emitting diodes are interconnected to form a string.

6. Installation according to Claim 1 or 2, **characterized in that** the support plate is made of a transparent material and **in that** the light-emitting source is arranged on the opposite plate face to the plate face that bears against the module.

7. Installation according to one of Claims 1 to 6, **characterized in that** the means for adjusting the position of the abrasive wire (F) comprise:
- optical capture means (7) for capturing the light signals (S_L) emitted through said photovoltaic module (M),
a control unit (UC) configured to determine the position of the abrasive wire (F) in said cutting plane, by analysing data received from the optical capture means (7) and indicative of said light signals (S_L) captured, and to adjust the feed speed (V1) and/or cutting speed (V2) of the abrasive wire (F) by taking into account the determined position of the abrasive wire (F).

8. Installation according to Claim 7, **characterized in that** the optical capture means (7) comprise at least a camera and/or one or more sensors.

9. Installation according to Claim 7 or 8, **characterized in that** the control unit (UC) is configured to:
- command first optical signals emitted through the photovoltaic module (M) by the back-lighting device (5) to be captured in the absence of the abrasive wire (F) to obtain first data indicative of these first optical signals,
- during the cutting, at all times, command second optical signals emitted through the photovoltaic module (M) by the back-lighting device (5) to be captured to obtain second data indicative of these second optical signals,
- compare the first data with the second data in order to determine the position of the abrasive wire (F) through the photovoltaic module (M).

10. Method for dismantling a photovoltaic module (M), said photovoltaic module comprising at least a first protective element (3) forming a transparent front face of the module, a second protective element (1) forming a back face of the photovoltaic module, photovoltaic cells (20) arranged between the first protective element and the second protective element, and an encapsulating housing (2) for the photovoltaic cells connecting the first protective element to the second protective element, said method being implemented on a dismantling installation as defined in one of Claims 1 to 9, said method being **characterized in that** it comprises:
- a step of emitting light signals (S_L) through the photovoltaic module (M) by using a back-lighting device (5),
- a step of determining the position of the abrasive wire (F) in said cutting plane,
- a step of adjusting the feed speed (V1) and/or the cutting speed (V2) of the abrasive wire (F) by taking into account the determined position of the abrasive wire.

11. Method according to Claim 10, **characterized in that** it comprises:
- a step of capturing light signals (S_L) emitted through said photovoltaic module (M) by said back-lighting device (5),
- a step of determining the speed of the abrasive wire (V) by analysing data indicative of said light radiation (R_L) captured.

12. Method according to Claim 10 or 11, **characterized in that** the step of determining the position of the abrasive wire comprises the following steps:
- acquiring first data indicative of first optical signals emitted through the photovoltaic module (M) by the back-lighting device (5),
- during the cutting, acquiring second data indicative of second optical signals emitted through the photovoltaic module (M) by the back-lighting device (5), in the presence of the abrasive wire (F),
- comparing the first data with the second data in order to determine the position of the abrasive wire through the photovoltaic module (M).
